# EUROPÄISCHE PATENTSCHRIFT

(11) **EP 1 476 776 B1**
(45) Veröffentlichungstag und Bekanntmachung des Hinweises auf die Patenterteilung: **07.06.2006**
(21) Anmeldenummer: 03702320.7
(22) Anmeldetag: 10.01.2003
(51) Int. Cl.: G02B 6/42, H01L 27/15, H01S 5/026, G02F 1/35, H01L 33/00

(54) **STRAHLFÜHRENDES UND/ODER FREQUENZKONVERTIERENDES OPTISCHES SYSTEM SOWIE VERFAHREN ZUR HERSTELLUNG**
BEAM-GUIDING AND/OR FREQUENCY-CONVERTING OPTICAL SYSTEM AND METHOD FOR PRODUCING THE SAME
SYSTEME OPTIQUE DE GUIDAGE DE FAISCEAU ET/OU DE CONVERSION DE FREQUENCE ET PROCEDE DE FABRICATION ASSOCIE

(30) Priorität: 21.02.2002 DE 10207334; 16.11.2002 DE 10253515
(43) Veröffentlichungstag der Anmeldung: 17.11.2004
(73) Patentinhaber: Fraunhofer-Gesellschaft zur Förderung der angewandten Forschung e.V., 80686 München (DE)
(72) Erfinder: GOTTMANN, Jens, 52070 Aachen (DE); HOFFMANN, Hans-Dieter, 52152 Simmerath (DE); RUSSBÜLDT, Peter, 52355 Düren (DE); SCHOLZ, Christian, 52064 Aachen (DE); BAUMANN, Markus, 56218 Mülheim-Kärlich (DE); BOUCKE, Konstantin, 52062 Aachen (DE)
(74) Vertreter: Gagel, Roland
(86) Internationale Anmeldenummer: PCT/DE2003/000053
(87) Internationale Veröffentlichungsnummer: WO 2003/073147

(56) Entgegenhaltungen:
- EP-A- 0 502 682
- US-A- 4 286 838
- US-A- 5 157 674
- US-A- 5 379 311
- US-A- 5 494 834
- US-B1- 6 340 605
- PATENT ABSTRACTS OF JAPAN vol. 011, no. 288 (E-542), 17. September 1987 (1987-09-17) -& JP 62 086881 A (MATSUSHITA ELECTRIC IND CO LTD), 21. April 1987 (1987-04-21)
- PATENT ABSTRACTS OF JAPAN vol. 017, no. 094 (E-1325), 24. Februar 1993 (1993-02-24) -& JP 04 287389 A (NEC CORP), 12. Oktober 1992 (1992-10-12)
- PATENT ABSTRACTS OF JAPAN vol. 012, no. 457 (E-688), 30. November 1988 (1988-11-30) -& JP 63 182882 A (TOSHIBA CORP), 28. Juli 1988 (1988-07-28)
- PATENT ABSTRACTS OF JAPAN vol. 2002, no. 03, 3. April 2002 (2002-04-03) -& JP 2001 332808 A (MINOLTA CO LTD), 30. November 2001 (2001-11-30)

## Beschreibung

### Technisches Anwendungsgebiet

Die vorliegende Erfindung betrifft ein Verfahren zur Herstellung eines strahlführenden und/oder frequenzkonvertierenden optischen Systems, bei dem ein strahlemittierendes optoelektronisches Bauelement, das zumindest eine Strahlaustrittsfläche für den Austritt eines Strahls aufweist, bereitgestellt und mit einer Oberfläche einer Unterlage so verbunden wird, dass der austretende Strahl annähernd parallel zur Oberfläche der Unterlage verläuft. Die Erfindung betrifft weiterhin ein strahlführendes und/oder frequenzkonvertierendes optisches System, das mit dem Verfahren herstellbar ist.

Die Führung und Konvertierung elektromagnetischer Strahlung aus optoelektronischen Bauelementen, wie beispielsweise Halbleiterdiodenlasern, spielt in vielen technischen Bereichen eine wesentliche Rolle, in denen optoelektronische Bauteile eingesetzt werden. Die aus dem optoelektronischen Bauelement austretende Strahlung wird hierbei in der Regel durch weitere optische Bauteile geführt oder geformt, um die für die jeweilige Anwendung erforderlichen Strahleigenschaften zu erreichen. In vielen Fällen ist auch eine Konvertierung der Frequenz der aus dem optoelektronischen Bauelement austretenden Strahlung zu einer höheren oder niedrigeren Frequenz erforderlich.

### Stand der Technik

In der Regel wird bisher die Führung und Konvertierung der elektromagnetischen Strahlung aus optoelektronischen Bauelementen durch weitere diskrete optische Bauelemente, wie Linsen, Lichtwellenleiter-Fasern oder Frequenzverdoppelnde Kristalle, in einem diskreten optischen Aufbau vorgenommen. Das optoelektronische Bauelement wird dabei ebenso wie die strahlführenden bzw. frequenzkonvertierenden Bauteile auf einer Unterlage montiert und justiert. Die Bereitstellung eines optischen Systems, bei dem die Strahlung des optoelektronischen Bauelements mit Linsen und/oder Spiegeln geformt und geführt und in lichtleitende Fasern eingekoppelt wird, erfordert zahlreiche Justageschritte. So muss das optoelektronische Bauelement zunächst auf der Unterlage ausgerichtet und montiert werden. Die Linsen und/oder Spiegel werden dann bezüglich des optoelektronischen Bauelements nacheinander justiert und auf der Unterlage fixiert. Anschließend wird die Lichtleitfaser auf der Unterlage justiert und montiert. Die präzise Justage und Montage der einzelnen diskreten Bauteile ist aufwendig und fehleranfällig. Zudem treten zwischen den separaten Bauteilen unerwünschte optische Verluste auf, die beispielsweise durch Reflexion, Streuung und Beugung des Lichtes hervorgerufen werden.

Aus der DE 695 10 238 T2 ist ein Mikrochip-Laser bekannt, der ein oder mehrere integrierte Elemente zur Strahlformung bzw. Frequenzkonvertierung aufweist. Mikrochip-Laser bestehen aus verbundenen polierten dielektrischen Materialien, wie Laserkristalle oder Frequenzverdoppler-Kristalle, die durch Hochleistungsdiodenlaser gepumpt werden. So zeigt die DE 695 10 238 T2 einen Mikrochip-Laser, der sich im Wesentlichen aus einer Schicht aus verstärkendem Material, einer Schicht aus einem Trägermaterial, beispielsweise Quarzkristall, und einer Schicht aus einem Frequenzverdoppelnden Kristall gebildet ist. Die Schicht des Trägermaterials dient der Montage des Lasers auf einer Unterlage, auf der auch der Diodenpumplaser montiert wird. Wird die Trägerschicht an einem Ende des Mikrochip-Lasers ausgebildet, so kann sie gleichzeitig durch geeignete Formung die Funktion einer strahlformenden Linse übernehmen. Für die Herstellung eines derartigen Mikrochip-Lasers müssen die Kontaktflächen der als verstärkende Schicht und als Frequenzverdoppelnde Schicht eingesetzten Kristalle sowie der Träger hochgradig poliert und eben sein, um sicherzustellen, dass sich die Materialien durch Van der Waals Kräfte miteinander verbinden, wenn sie zusammengepresst werden. Die Herstellung eines derartigen Mikrochip-Lasers ist daher aufwendig. Mikrochip-Laser erzielen bei vergleichbaren Ausgangsleistungen eine deutlich verbesserte Strahlqualität im Vergleich zu Laserdioden im sichtbaren Spektralbereich. Nachteilig ist allerdings die unzureichende Stabilität der Strahlachse (Beam Point Stability) dieser Laser, wodurch viele Anwendungsmöglichkeiten, beispielsweise in der Messtechnik, wie Lasertriangulation und in der Drucktechnik ausgeschlossen bleiben.

Ein weiteres bekanntes strahlführendes und/oder frequenzkonvertierendes optisches System setzt die Technik der gebondeten Wellenleiter ein. Gebondete planare Wellenleiter und Wellenleiter-Laser werden aus dünnen polierten Einkristallen zusammengefügt und über eine Strahlformung, bestehend aus zwei Zylinderlinsen mit Hochleistungsdiodenlasern gepumpt. Ein Beispiel für den Einsatz dieser Technik der gebondeten Wellenleiter ist beispielsweise aus C. Li et al., Longitudinally-Diode-Pumped High-Power Waveguide Lasers, Proceedings 10th European Conference on Integrated Optics, Paderborn, Germany, Seiten 83 - 86, 2001 bekannt. Die hierbei eingesetzten Wellenleiter-Laser bestehen aus einer Schichtkombination aus Saphir, YAG, Nd:YAG, YAG und Saphir, wobei die einzelnen Schichten eine Dicke von nur etwa 5 bis 20 *µ*m bei einer Fläche im Bereich von Quadratzentimetern aufweisen. Mit derartigen Wellenleiterlasern werden Leistungen von größer 1 Watt nahezu beugungsbegrenzt bei einer Wellenlänge von 1064 nm erreicht. Nachteilig an diesem Konzept ist jedoch die extrem aufwendige Dünnung der Kristallplättchen sowie die aufwendige Justage und Montage, die zu einem sehr hohen Herstellungsaufwand führen.

Aus der US 5,379,311 A ist ein frequenzkonvertierendes, strahlführendes Wellenleitersystem bekannt. Das Wellenleitersystem umfasst eine aktive Halogenide enthaltende Schicht, die von einer einkristallinen, ebenfalls Halogenide enthaltenden Ummantelungsschicht umgeben ist. Die aktive Schicht besitzt einen höheren Brechungsindex als die Ummantelungsschicht. Das beschriebene Wellenleitersystem kann auf einer Substratoberfläche mit einer ebenfalls auf der Substratoberfläche angeordneten Laserdiode monolithisch verbunden werden. Dabei dient die Laserdiode als Lichtquelle für das frequenzkonvertierende Wellenleitersystem.

Aus JP 62 086 881 A geht eine Vorrichtung hervor mit der die Umwandlungseffektivität von sekundären harmonischen Wellen erhöht werden soll. Dabei wird ein Wellenleitersystem mit einem nichtlinearen optischen Medium auf einem Substrat derart angeordnet, dass das nichtlineare optische Medium an den aktiven Bereich eines Halbleiterlasers anschließt. Das Wellenleitersystem besteht aus drei übereinander liegenden Schichten. Die mittlere Schicht besteht aus dem nichtlinearen optischen Medium, die beiden äußeren Schichten enthalten ZnS.

Aus US 6,340,605 B1 geht ein integriertes Wellenleitersystem mit einem Halbleiterlaser sowie ein Verfahren zur Herstellung desselben hervor. Das Wellenleitersystem besteht aus einer Vielzahl halbleitender Schichten. Der Halbleiterlaser sowie das Wellenleitersystem werden gemeinsam, d.h. integral, auf einer Substratoberfläche hergestellt. Zwischen dem Halbleiterlaser und dem Wellenleitersystem ist eine halbleitende Schicht vorgesehen.

Aus JP 2001 332 808 A geht eine Vorrichtung mit mehreren Lichtquellen, einem aus mehreren einzelnen Wellenleitern zusammengesetzten Wellenleitersystem sowie mit mehreren lichtdurchlässigen fotoelektrischen Wandlern hervor. Die Vorrichtung soll eine hochgenaue Regelung der Lichtmenge ermöglichen, die von dieser Vorrichtung erzeugt wird. Der von einer Lichtquelle erzeugte Lichtstrahl wird über einen eigenen, an die Lichtquelle gekoppelten Wellenleiter zu einem der Lichtquelle zugeordneten fotoelektrischen Wandler geleitet. Das die Vorrichtung verlassende Licht setzt sich aus den Beiträgen zusammen, die durch die einzelnen fotoelektrischen Wandler hindurch treten. Die einzelnen fotoelektrische Wandler erfassen die von der ihnen jeweils zugeordneten Lichtquelle ausgesandten Lichtmenge. Über einen Regelkreis wird die Ansteuerung der jeweiligen Lichtquelle und somit deren ausgesandte Lichtemenge verändert.

Aus US 5,157,674 A geht ein Verfahren zur Bearbeitung eines glasartigen Materials hervor, wobei das Material nach dessen Bearbeitung bei Einkoppelung von Licht einer Frequenz, Licht der doppelten Frequenz aussendet. Des Weiteren wird ein optisches Bauelement beschrieben, welches aus einem Substrat besteht, auf das ein Diodenlaser als Strahlungsquelle und ein daran optisch gekoppeltes frequenzverdoppelndes Mittel aufgebracht sind. Dieses Mittel ist einschichtig aufgebaut und besteht aus dem glasartigen Material, das mit dem beschrieben Verfahren bearbeitet wurde

Aus US 5,494,834 A geht ein Verfahren zur Herstellung eines optoelektronischen Bauelements mit einer Lichtquelle und einem Lichtwellen leitenden Mehrschichtsystem hervor. Das Lichtwellen leitende Mehrschichtsystem besteht dabei aus einem Siliziumsubstrat und zwei darauf aufgebrachten Schichten: einer ersten aus Siliziumdioxid bestehenden Schicht, die zwei rinnenartige Auskehlungen aufweist und einer zweiten Schicht, die aus einem Licht leitenden Material besteht. Die rinnenartige Auskehlungen und Teile der ersten Schicht werden dabei durch lokale Oxidation des Siliziumsubstrats erzeugt. Die rinnenartige Auskehlung mit ihrer glatten Oberfläche ermöglicht nach dem Aufbringen des Licht leitenden Materials eine nahezu verlustfreie Lichtwellenleitung. Zur Lichteinkoppelung in das Licht leitende Material wird, entsprechend des offenbarten Herstellungsverfahrens, nach dem Aufbringen der ersten Schicht sowie der Ausbildung der rinnenartigen Auskehlungen des mehrschichtigen Wellenleiters eine bereit gestellte Lichtquelle (Diodenlaser) auf die rinnenartige Auskehlung der ersten Schicht aufgebracht

Aus US 4,286,838 A geht ein komplexes optisches System mit einem flächig ausgebildeten mehrschichtigen Lichtwellenleiter und mindestens einer Lichtquelle hervor. Der Lichtwellenleiter besteht dabei aus einem Siliziumsubstrat, einer darauf aufgebrachten ersten Schicht aus Siliziumdioxid und einer Licht leitenden zweiten Schicht aus einem Photopolymermaterial. Die Lichtquelle, bspw. ein Laser oder eine Licht emittierende Diode, wird an die Licht leitende zweite Schicht optisch angekoppelt. Im Hinblick auf die Herstellung des Lichtwellenleiters wird vor der Verbindung der Lichtquelle (bspw. der Laserdiode) mit der Unterlage, eine Abscheidung zumindest der ersten Schicht, des aus mehreren Schichten bestehenden Wellenleiters, auf die Unterlage durchgeführt.

Ausgehend von diesem Stand der Technik besteht die Aufgabe der vorliegenden Erfindung darin, ein Verfahren zur Herstellung eines strahlführenden und/oder frequenzkonvertierenden optischen Systems anzugeben, das einen geringen Herstellungsaufwand erfordert und zu einem optischen System hoher Effizienz führt. Weiterhin soll ein mit dem Verfahren herstellbares strahlführendes und/oder frequenzkonvertierendes optisches System hoher Effizienz bereitgestellt werden.

### Darstellung der Erfindung

Die Aufgabe wird mit dem Verfahren sowie dem System gemäß den Patentansprüchen 1 bzw. 13 gelöst. Vorteilhafte Ausgestaltungen des Verfahrens sowie des Systems sind Gegenstand der Unteransprüche oder lassen sich aus der nachfolgenden Beschreibung sowie den Ausführungsbeispielen entnehmen.

Beim vorliegenden Verfahren zur Herstellung eines strahlführenden und/oder frequenzkonvertierenden optischen Systems wird ein strahlemittierendes optoelektronisches Bauelement bereitgestellt, das zumindest eine Strahlaustrittsfläche für den Austritt eines Strahls aufweist und mit einer Oberfläche einer Unterlage so verbunden ist, dass der austretende Strahl annähernd parallel zur Oberfläche der Unterlage verläuft. Nach der Verbindung des optoelektronischen Bauelements mit der Unterlage, beispielsweise einem Trägersubstrat, wird ein aus mehreren glasartigen oder keramischen Schichten zusammengesetztes lichtwellenleitendes Schichtsystem für eine Führung und/oder Frequenzkonvertierung des Strahls derart auf der Oberfläche der Unterlage abgeschieden und strukturiert und/oder lokal modifiziert, dass ein direkter Kontakt zwischen der Strahlaustrittsfläche des optoelektronischen Bauelements und dem Schichtsystem entsteht und eine vorgebbare Strahlführung erreicht wird.

Mit dem vorliegenden Verfahren wird somit ein neuartiges System aus lichtleitenden Wellenleitern vor optoelektronischen Strahlquellen zur Führung und/oder Konvertierung des Lichtes der Strahlquelle bereitgestellt, bei dem die Wellenleiter in direktem Kontakt zur Strahlquelle durch Schichtabscheidung und Strukturierung und/oder Modifizierung des Schichtsystems auf einer gemeinsamen Unterlage hergestellt werden. Die einzelnen Schichten des Schichtsystems bestehen dabei erfindungsgemäß aus glasartigen oder keramischen Materialien, die selbstverständlich die Transmission des Lichtes zur Strahlführung bzw. Frequenzkonvertierung ermöglichen müssen. Bei dem vorliegenden Verfahren handelt es sich somit im Gegensatz zu der in der Einleitung beschriebenen Technik der Herstellung von Mikrochip-Lasern nicht um eine monolithische sondern um eine hybride Integration optischer und optoelektronischer Bauelemente.

Ein wesentlicher Vorteil des vorliegenden Verfahrens sowie des zugehörigen Systems liegt in einer Steigerung der Effizienz des optischen Systems, da Einkoppelverluste zwischen dem optoelektronischen Bauelement und dem wellenleitenden Schichtsystem durch den direkten Kontakt vermieden werden, welche bei diskretem optischen Aufbau unvermeidbar sind. Weiterhin führt das vorliegende Verfahren zu einer Effizienzsteigerung bei der Herstellung derartiger optischer Systeme, da durch die hybride Integration der wellenleitenden Strukturen mit dem optoelektronischen Bauelement auf einer gemeinsamen Unterlage aufwendige Justage- und Montageschritte eingespart werden. Auch gegenüber den Techniken der Herstellung von Mikrochip-Lasern oder gebondeten Wellenleitern hat das vorliegende Verfahren Vorteile, da ein aufwendiges Polieren sowie eine Justage der strahlführenden bzw. frequenzkonvertierenden wellenleitenden Struktur nicht erforderlich ist.

Ein oder mehrere der Schichten des wellenleitenden Schichtsystems werden beim vorliegenden Verfahren so strukturiert, dass die daraus resultierende wellenleitende Struktur die gewünschte Führung oder Formung des aus dem optoelektronischen Bauelement austretenden Strahles ermöglicht. Die geeignete Wahl der Materialien und Dimensionen dieser Schichtstruktur sind dem Fachmann geläufig. Das wellenleitende Schichtsystem besteht dabei vorzugsweise aus zumindest drei übereinander liegenden Schichten, von denen die mittlere Schicht einen höheren Brechungsindex aufweist als die beiden benachbarten Schichten. Die Strukturierung einzelner Schichten des wellenleitenden Schichtsystems bzw. des gesamten Schichtsystems kann bereits durch eine strukturierte Abscheidung unter Einsatz einer oder mehrerer Masken erfolgen. Weiterhin lassen sich die Schichten auch durch abtragende Prozesse nach der Schichtabscheidung geeignet strukturieren. Auch eine lokale Modifikation der Schichteigenschaften der abgeschiedenen Schichten, beispielsweise durch Einwirkung von Laserstrahlung für eine lokale Änderung des Brechungsindex, ist selbstverständlich möglich.

Sowohl für die Schichtabscheidung als auch für die Strukturierung bzw. Modifizierung werden Prozesse eingesetzt, die weder das optoelektronische Bauelement noch die Verbindung zwischen optoelektronischem Bauelement und der Unterlage in der Funktion beeinträchtigen. Insbesondere hohe Temperaturen und hohe elektrische Felder müssen hierbei vermieden werden. Erfindungsgemäß werden für die Abscheidung und Strukturierung und/oder lokale Modifizierung Niedertemperaturprozesse eingesetzt. Daher kommen vorzugsweise Verfahren mit hyperthermischen Partikeln wie schnellen Ionen sowie gepulste Laserstrahlung zum Einsatz, beispielsweise Verfahren der Laserdeposition, der Ionenstrahldeposition, der Kathodenzerstäubung, des reaktiven Ionenätzens oder des Abtrags oder der Brechungsindexänderung mit gepulster Laserstrahlung. Zur Herstellung des direkten Kontaktes zwischen dem wellenleitenden Schichtsystem und der zumindest einen Strahlaustrittsfläche des optoelektronischen Bauelements sollte eine im Wesentlichen gerichtete Abscheidung unter einem Winkel annähernd parallel zur Strahlaustrittsfläche des optoelektronischen Bauteils gewählt werden.

Für eine frequenzkonvertierende Funktion wird erfindungsgemäß ein wellenleitendes Schichtsystem abgeschieden, bei dem zumindest eine Schicht aus einem laseraktiven, d.h. beispielsweise fluoreszierenden Material gebildet wird, das durch die Frequenz des aus dem optoelektronischen Bauelement austretenden Strahls (erste Frequenz) anregbar ist und bei der Anregung Strahlung einer höheren oder niedrigeren Frequenz (zweite Frequenz) emittiert. Auf diese Weise lässt sich die erste Frequenz des aus dem optoelektronischen Bauelement austretenden Strahls in eine zweite Frequenz konvertieren, die dann auf einer Strahlaustrittsseite der wellenleitenden Schichtstruktur austritt. Geeignete Materialien für eine derartige so genannte Up-Conversion oder Down-Conversion sind dem Fachmann bekannt.

Darüber hinaus wird bzw. ist erfindungsgemäß die Strahlaustrittsseite des wellenleitenden Schichtsystems, das zumindest eine Schicht aus einem laseraktiven Material beinhaltet, mit einer Strahlung der zweiten Frequenz reflektierenden Schicht beschichtet, so dass mit der Strahlaustrittsfläche des optoelektronischen Bauelements ein optischer Resonator für Strahlung der zweiten Frequenz gebildet wird. Falls für die Funktion als Resonator erforderlich kann die Strahlaustrittsfläche des optoelektronischen Bauelements vor dem Aufbringen des Schichtsystems auf die Unterlage zusätzlich für die zweite Frequenz reflektierend beschichtet werden. Auf diese Weise wird ein Wellenleiter-Laser durch die wellenleitende Struktur gebildet, der durch das optoelektronische Bauelement gepumpt wird. Selbstverständlich muss hierfür die gegebenenfalls aufgebrachte, für die zweite Frequenz reflektierende Beschichtung der Strahlaustrittsfläche des optoelektronischen Bauelements für die erste Frequenz durchlässig sein. In einer Ausgestaltung können auch weitere Spiegel durch Strukturieren, Polieren und/oder nachfolgendes Beschichten mit dielektrischen oder metallischen Schichten hinzugefügt werden. Ein Spiegel kann beispielsweise durch eine Struktur in Form eines V-förmigen Retroreflektors auf der Unterlage gebildet werden.

Auch wenn sich die vorangehende Beschreibung im Wesentlichen auf ein optoelektronisches Bauelement mit einer Strahlaustrittsfläche bezieht, über die ein Strahl emittiert wird, so lassen sich beim vorliegenden Verfahren sowie dem zugehörigen System selbstverständlich auch optoelektronische Bauelemente einsetzen, die mehrere Strahlen über mehrere Strahlaustrittsflächen emittieren. Das optoelektronische Bauelement kann beispielsweise ein einzelner Halbleiterdiodenlaser mit mehreren Strahlaustrittsflächen sein oder durch mehrere aneinander gereihte Strahlquellen gebildet sein. Der Einsatz eines optoelektronischen Bauelements, das mehrere Strahlquellen, insbesondere in Form von Halbleiterdiodenlasern, enthält, bietet insbesondere Vorteile beim Pumpen eines durch das wellenleitende Schichtsystem gebildeten Wellenleiter-Lasers. Ein wesentliches Merkmal des vorliegenden Verfahrens ist der Einsatz eines bereits fertig gestellten, d.h. voll funktionsfähigen, optoelektronischen Bauelements, das beispielsweise kommerziell erworben sein kann und auf der Unterlage montiert wird.

Bei Einsatz eines optoelektronischen Bauelements, das mehrere Strahlen über mehrere Strahlaustrittsflächen emittiert, wird das wellenleitende Schichtsystem derart abgeschieden und strukturiert, dass alle austretenden Strahlen in der gewünschten Weise in diesem wellenleitenden Schichtsystem geführt werden. In einer vorteilhaften Ausgestaltung werden die einzelnen Strahlen durch das wellenleitende Schichtsystem auf eine verringerte Strahlaustrittsfläche zusammengeführt, so dass auf der Strahlaustrittsseite des wellenleitenden Schichtsystems ein Strahl mit geringem Strahlquerschnitt und hoher Intensität zur Verfügung steht. Das wellenleitende Schichtsystem ist dabei in Form eines Strahlkopplers ausgeführt.

Vorzugsweise wird als Unterlage ein metallisches oder dielektrisches Substrat, insbesondere ein Kühlkörper eingesetzt. Durch diese Ausgestaltung wird gleichzeitig eine verbesserte Kühlung des optischen Systems erreicht. Bei der Ausgestaltung als Kühlkörper kann die Unterlage beispielsweise an der Unterseite Kühlrippen aufweisen oder integrierte Kühlkanäle oder sonstige Mittel zur Kühlung. Die Verbindung zwischen der Unterlage und dem optoelektronischen Bauelement kann beispielsweise über eine Lot- oder Klebeverbindung erfolgen.

### Kurze Beschreibung der Zeichnungen

Das vorliegende Verfahren sowie das zugehörige System werden nachfolgend anhand von Ausführungsbeispielen in Verbindung mit den Zeichnungen ohne Beschränkung des allgemeinen Erfindungsgedankens nochmals kurz erläutert. Hierbei zeigen:
- Fig. 1: ein optisches System gemäß der vorliegenden Erfindung in unterschiedlichen Ansichten;
- Fig. 2: beispielhaft einzelne Verfahrensschritte des vorliegenden Verfahrens zur Herstellung eines optischen Systems gemäß Fig. 1; und
- Fig. 3: ein Beispiel für ein optisches System mit einem Wellenleiter-Laser gemäß der vorliegenden Erfindung.

### Wege zur Ausführung der Erfindung

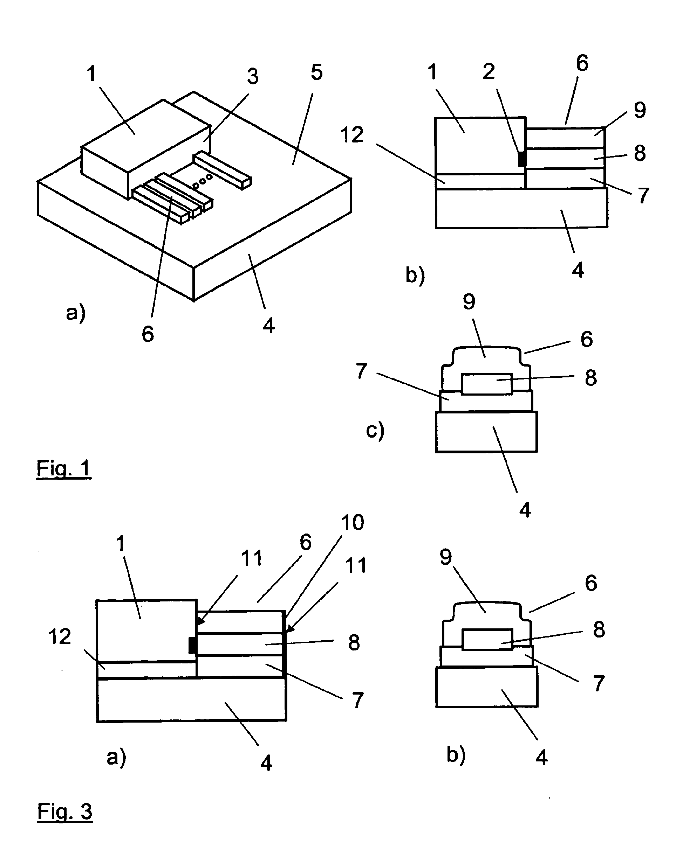

Fig. 1 zeigt schematisiert ein Beispiel für ein optisches System gemäß der vorliegenden Erfindung in verschiedenen Ansichten. Teilansicht a) zeigt hierbei eine perspektivische Ansicht eines derartigen optischen Systems. Aus dieser Teilansicht ist das strahlemittierende optoelektronische Bauelement 1, im vorliegenden Fall ein Halbleiterdiodenlaser mit mehreren Strahlaustrittsflächen für die Emission mehrerer nebeneinander liegender Strahlen, zu erkennen, der auf der Oberfläche 5 einer Unterlage 4 montiert ist. Auf der Strahlaustrittsseite 3 des optoelektronischen Bauelements 1 ist eine wellenleitende Struktur in Form eines wellenleitenden Schichtsystems 6 in direktem Kontakt zu den Strahlaustrittsflächen des optoelektronischen Bauelements 1 aufgebracht. Die einzelnen aus dem optoelektronischen Bauelement 1 austretenden Strahlen werden hierbei durch die im vorliegenden Beispiel gebildeten, nebeneinander liegenden Wellenleiter des wellenleitenden Schichtsystems 6 geführt.

In der Teilansicht b) ist diese Anordnung nochmals im Querschnitt längs der Strahlachsen der aus dem optoelektronischen Bauelement 1 austretenden Strahlen dargestellt. In dieser Darstellung ist die Verbindungsschicht 12 zwischen dem optoelektronischen Bauelement 1 und der Unterlage 4 zu erkennen. Das wellenleitende Schichtsystem 6 besteht aus drei übereinander liegenden Schichten 7 bis 9, von denen die mittlere Schicht 8 einen höheren Brechungsindex als die benachbarten Schichten 7, 9 aufweist. Auf diese Weise wird ein Wellenleiter für die aus dem optoelektronischen Bauelement 1 über die hier erkennbare Strahlaustrittsfläche 2 austretende Strahlung gebildet. Die mittlere Schicht 8 steht in direktem Kontakt zur Strahlaustrittsfläche 2.

Teilabbildung c) zeigt nochmals einen Ausschnitt aus diesem optischen System im Schnitt senkrecht zur Strahlachse. In dieser Darstellung ist der durch das wellenleitende Schichtsystem 6 gebildete Wellenleiter für einen einzelnen Strahl des optoelektronischen Bauelements 1 gut zu erkennen. Durch die Abscheidung der einzelnen Schichten 7 bis 9 dieses wellenleitenden Schichtsystems 6 lässt sich erreichen, dass der mittlere Schichtbereich 8 von den benachbarten Schichten 7 und 9 vollständig umschlossen ist.

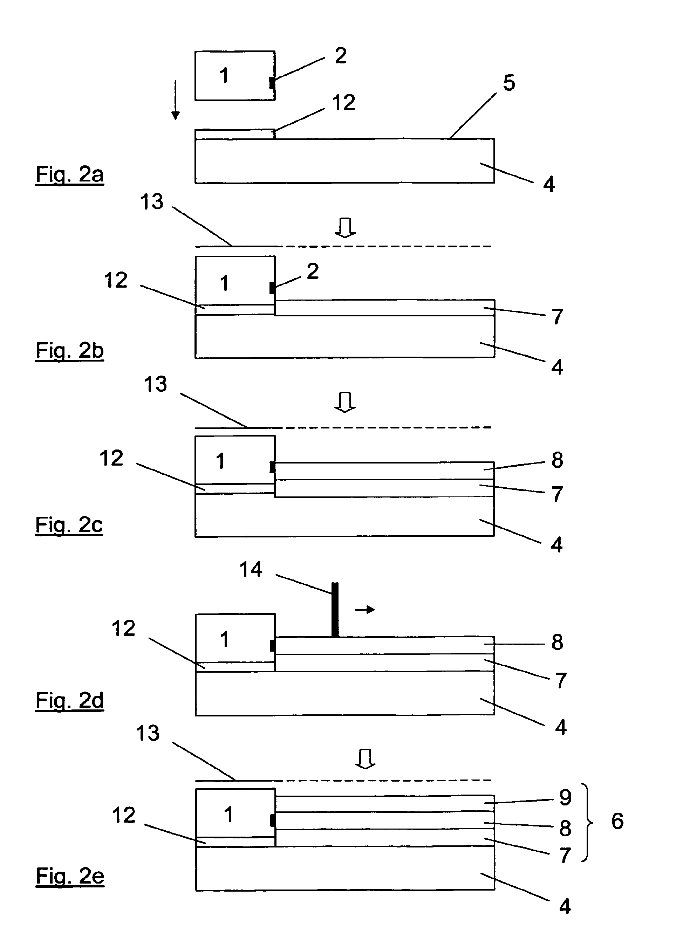

Fig. 2a) zeigt beispielhaft eine Möglichkeit der Herstellung des in Fig. 1 dargestellten optischen Systems gemäß dem vorliegenden Verfahren. Im ersten Schritt (Fig. 2a) wird eine Lotschicht 12 auf einem Bereich einer Unterlage 4 aufgebracht und anschließend das optoelektronische Bauelement 1 über diese Lotschicht 12 mit der Unterlage 4 verbunden, so dass sich eine freie Oberfläche der Unterlage 4 in Strahlrichtung vor der Strahlaustrittsfläche 2 des optoelektronischen Bauelements 1 befindet.

Anschließend wird ein lichtwellenleitendes Schichtsystem 6 derart vor dem optoelektronischen Bauelement 1 auf der Unterlage 4 deponiert, dass die aus der Strahlaustrittsfläche 2 austretende Strahlung innerhalb der Schichten geführt wird. Die Ausbreitung der Strahlung ist dabei in bekannter Weise auf gewünschte Richtungen beschränkt. Zunächst wird eine untere Schicht 7 des Schichtsystems 6 über eine Maske 13 in direktem Kontakt zum optoelektronischen Bauelement 1 auf der Oberfläche 5 der Unterlage 4 deponiert (Fig. 2b). Nach der Abscheidung der unteren Schicht 7 folgt die Abscheidung einer mittleren Schicht 8 in der gleichen Weise mit Hilfe einer Maske 13, durch die insbesondere das optoelektronische Bauelement 1 abgedeckt wird (Fig. 2c).

Die mittlere Schicht 8 wird im vorliegenden Beispiel mit Hilfe eines Laserstrahls 14 anschließend strukturiert (Fig. 2d), so dass sich nebeneinander liegende Wellenleiter ausbilden, wie dies in der Teilabbildung a) der Fig. 1 angedeutet ist. Schließlich folgt die Abscheidung der oberen Schicht 9, wiederum über die Maske 13, so dass sich die in Fig. 1 gezeigte Anordnung der wellenleitenden Struktur 6 ergibt.

Die Abscheidung der einzelnen Schichten 7 bis 9 des Schichtsystems 6 erfolgt in diesem Beispiel durch eine geeignete Plasmaabscheidung, wie Laserdeposition, die Strukturierung der mittleren Schicht 9 beispielsweise durch Laserablation.

Fig. 3 zeigt schließlich ein weiteres Beispiel eines optischen Systems gemäß der vorliegenden Erfindung in zwei Teilansichten a) und b), die den Ansichten b) und c) der Fig. 1 entsprechen. In diesem Beispiel besteht die mittlere Schicht 8 des wellenleitenden Schichtsystems 6 aus einem laseraktiven Material, das durch die Strahlung des optoelektronischen Bauelements 1 als Pumpquelle gepumpt werden kann. In der Teilabbildung a) sind weiterhin zwei Resonatorspiegel in Form von Beschichtungen 11 auf der Strahlaustrittsseite 10 des wellenleitenden Schichtsystems 6 sowie auf der Strahlaustrittsseite 3 des optoelektronischen Bauelements 1 angedeutet. Durch diese Resonatorspiegel, repräsentiert das wellenleitende Schichtsystem 6 einen Wellenleiter-Laser, der in direktem Kontakt zur Pumpstrahlquelle, dem optoelektronischen Bauelement 1, auf einer gemeinsamen Unterlage 4 realisiert ist. Werden die beiden Resonatorspiegel 11 weggelassen, so lässt sich auf diese Weise eine einfache Frequenzkonvertierung der Strahlung des optoelektronischen Bauelements 1 erreichen. Teilansicht b) zeigt wiederum den grundsätzlichen Aufbau des wellenleitenden Schichtsystems 6 für einen Strahl in einem Schnitt senkrecht zur Strahlrichtung.

### BEZUGSZEICHENLISTE

| | |
|---|---|
| 1 | Optoelektronisches Bauelement |
| 2 | Strahlaustrittsfläche |
| 3 | Strahlaustrittsseite des optoelektronischen Bauelements |
| 4 | Unterlage bzw. Trägersubstrat |
| 5 | Oberfläche der Unterlage |
| 6 | Wellenleitendes Schichtsystem |
| 7 | Untere Schicht |
| 8 | Mittlere Schicht |
| 9 | Obere Schicht |
| 10 | Strahlaustrittsseite des wellenleitenden Schichtsystems |
| 11 | (Teil-)Reflektierende Beschichtung (Resonatorspiegel) |
| 12 | Verbindungsschicht |
| 13 | Maske |
| 14 | Laserstrahl |

## Patentansprüche

1. Verfahren zur Herstellung eines strahlführenden und/oder frequenzkonvertierenden optischen Systems, bei dem ein strahlemittierendes optoelektronisches Bauelement (1), das zumindest eine Strahlaustrittsfläche (2) für den Austritt eines Strahls aufweist, bereitgestellt und mit einer Oberfläche (5) einer Unterlage (4) so verbunden wird, dass der austretende Strahl annähernd parallel zur Oberfläche (5) der Unterlage (4) verläuft,
**dadurch gekennzeichnet,**
**dass** das strahlführende optoelektronische Bauelement (1) zunächst auf der Oberfläche (5) der Unterlage (4) montiert wird und anschließend ein aus mehreren glasartigen oder keramischen Schichten (7, 8, 9) zusammen gesetztes wellenleitendes Schichtsystem (6) für eine Führung und/oder Frequenzkonvertierung des Strahls derart auf der Oberfläche (5) der Unterlage (4) abgeschieden und strukturiert und/oder lokal modifiziert wird, dass ein direkter Kontakt zwischen der Strahlaustrittsfläche (2) und dem Schichtsystem (6) entsteht und eine vorgebbare Strahlführung erreicht wird,
**dass** für die Abscheidung und Strukturierung und/oder lokale Modifizierung Niedertemperaturprozesse eingesetzt werden,
**dass** zumindest eine Schicht (8) des wellenleitenden Schichtsystems (6) aus einem laseraktiven Material gebildet wird, das durch eine erste Frequenz des aus dem optoelektronischen Bauelement (1) austretenden Strahls anregbar ist und bei Anregung Strahlung einer höheren oder niedrigeren zweiten Frequenz emittiert, und
**dass** eine Strahlaustrittsseite (10) des wellenleitenden Schichtsystems (6) und gegebenenfalls die Strahlaustrittsfläche (2) des optoelektronischen Bauelements (1) mit einer Strahlung der zweiten Frequenz teilreflektierenden Schicht (11) beschichtet werden, um einen optischen Resonator für Strahlung der zweiten Frequenz zu bilden.

2. Verfahren nach Anspruch 1,
**dadurch gekennzeichnet,**
**dass** als wellenleitendes Schichtsystem (6) zumindest drei übereinander liegende Schichten (7, 8, 9) abgeschieden werden, von denen eine mittlere Schicht (8) einen höheren Brechungsindex aufweist als die benachbarten Schichten (7, 9).

3. Verfahren nach einem der Ansprüche 1 bis 2,
**dadurch gekennzeichnet,**
**dass** eine metallische oder keramische Unterlage (4) eingesetzt wird.

4. Verfahren nach einem der Ansprüche 1 bis 3,
**dadurch gekennzeichnet,**
**dass** ein Kühlkörper als Unterlage (4) eingesetzt wird.

5. Verfahren nach einem der Ansprüche 1 bis 4,
**dadurch gekennzeichnet,**
**dass** das optoelektronische Bauelement (1) und die Unterlage (4) durch Löten verbunden werden.

6. Verfahren nach einem der Ansprüche 1 bis 5,
**dadurch gekennzeichnet,**
**dass** die Strukturierung während der Abscheidung einzelner oder aller Schichten (7, 8, 9) des Schichtsystems (6) durch Einsatz einer oder mehrerer Abscheidemasken erfolgt.

7. Verfahren nach einem der Ansprüche 1 bis 5,
**dadurch gekennzeichnet,**
**dass** die Strukturierung nach der Abscheidung einzelner oder aller Schichten (7, 8, 9) des Schichtsystems (6) durch lokale Abtragung erfolgt.

8. Verfahren nach einem der Ansprüche 1 bis 7,
**dadurch gekennzeichnet,**
**dass** die Modifizierung durch lokal begrenzte Energieeinwirkung zur Änderung von Schichteigenschaften, insbesondere des Brechungsindex, erfolgt.

9. Verfahren nach einem der Ansprüche 1 bis 8,
**dadurch gekennzeichnet,**
**dass** in direkten Kontakt zum wellenleitenden Schichtsystem (6) ein oder mehrere weitere Schichten auf der Unterlage (4) abgeschieden und strukturiert werden, um weitere optische Bauelemente zu bilden.

10. Verfahren nach einem der Ansprüche 1 bis 9,
**dadurch gekennzeichnet,**
**dass** ein optoelektronisches Bauelement (1) mit mehreren Strahlaustrittsflächen (2) eingesetzt wird, wobei das wellenleitende Schichtsystem (6) für die Führung und/oder oder Frequenzkonvertierung der aus den mehreren Strahlaustrittsflächen (2) austretenden Strahlen strukturiert und/oder lokal modifiziert wird.

11. Verfahren nach Anspruch 10,
**dadurch gekennzeichnet,**
**dass** das wellenleitende Schichtsystem (6) derart strukturiert und/oder lokal modifiziert wird, dass die aus den mehreren Strahlaustrittsflächen (2) austretenden Strahlen auf eine verringerte Strahlaustrittsfläche zusammengeführt werden.

12. Verfahren nach einem der Ansprüche 1 bis 11,
**dadurch gekennzeichnet,**
**dass** ein optoelektronisches Bauelement (1) mit ein oder mehreren Halbleiterdiodenlasern eingesetzt wird.

13. Strahlführendes und/oder frequenzkonvertierendes optisches System, bei dem ein strahlemittierendes optoelektronisches Bauelement (1), das zumindest eine Strahlaustrittsfläche (2) für den Austritt eines Strahls aufweist, mit einer Oberfläche (5) einer Unterlage (4) so verbunden ist, dass der austretende Strahl annähernd parallel zur Oberfläche (5) der Unterlage (4) verläuft,
**dadurch gekennzeichnet,**
**dass** das strahlemittierende optoelektronische Bauelement (1) auf der Oberfläche (5) der Unterlage (4) montiert ist und in einem direkten Kontakt zur Strahlaustrittsfläche (2) ein aus mehreren glasartigen oder keramischen Schichten (7, 8, 9) zusammen gesetztes und strukturiertes wellenleitendes Schichtsystem (6) für eine Führung und/oder oder Frequenzkonvertierung des Strahls auf der Oberfläche (5) der Unterlage (4) abgeschieden ist,
**dass** zumindest eine Schicht (8) des wellenleitenden Schichtsystems (6) aus einem laseraktiven Material gebildet ist, das durch eine erste Frequenz des aus dem optoelektronischen Bauelement (1) austretenden Strahls anregbar ist, um bei Anregung Strahlung einer höheren oder niedrigeren zweiten Frequenz zu emittieren,
**dass** eine Strahlaustrittsseite (10) des wellenleitenden Schichtsystems (6) und gegebenenfalls die Strahlaustrittsfläche (2) des optoelektronischen Bauelements (1) mit einer Strahlung der zweiten Frequenz teilreflektierenden Schicht (11) beschichtet sind, um einen optischen Resonator für Strahlung der zweiten Frequenz zu bilden.

14. System nach Anspruch 13,
**dadurch gekennzeichnet,**
**dass** das wellenleitende Schichtsystem (6) aus zumindest drei übereinander liegende Schichten (7, 8, 9) gebildet ist, von denen eine mittlere Schicht (8) einen höheren Brechungsindex aufweist als die benachbarten Schichten (7, 9).

15. System nach einem der Ansprüche 13 bis 14,
**dadurch gekennzeichnet,**
**dass** die Unterlage (4) aus Metall oder Keramik besteht.

16. System nach einem der Ansprüche 13 bis 15,
**dadurch gekennzeichnet,**
**dass** die Unterlage (4) ein Kühlkörper ist.

17. System nach einem der Ansprüche 13 bis 16,
**dadurch gekennzeichnet,**
**dass** in direkten Kontakt zum wellenleitenden Schichtsystem (6) ein oder mehrere weitere strukturierte Schichten auf der Unterlage (4) abgeschieden sind, die weitere optische Bauelemente bilden.

18. System nach einem der Ansprüche 13 bis 17,
**dadurch gekennzeichnet,**
**dass** das optoelektronische Bauelement (1) mehrere Strahlaustrittsflächen (2) aufweist, wobei das wellenleitende Schichtsystem (6) für die Führung und/oder oder Frequenzkonvertierung der aus den mehreren Strahlaustrittsflächen (2) austretenden Strahlen strukturiert und/oder lokal modifiziert ist.

19. System nach Anspruch 18,
**dadurch gekennzeichnet,**
**dass** das wellenleitende Schichtsystem (6) derart strukturiert und/oder lokal modifiziert ist, dass die aus den mehreren Strahlaustrittsflächen (2) austretenden Strahlen auf eine verringerte Strahlaustrittsfläche zusammengeführt werden.

20. System nach einem der Ansprüche 13 bis 19,
**dadurch gekennzeichnet,**
**dass** das optoelektronische Bauelement (1) ein oder mehrere Halbleiterdiodenlaser enthält.

## Claims

1. Method of manufacturing a beam-guiding and/or frequency-converting optical system, wherein a beam-emitting optoelectronic component (1) comprising at least one beam exit surface (2) for the emergence of a beam, is provided and connected to a surface (5) of a base (4) in such a manner that the emerging beam extends approximately in parallel with the surface (5) of said base (4),
**characterised in**
**that** said beam-guiding optoelectronic component (1) is initially mounted on said surface (5) of said base (4) and that subsequently a wave-guiding stratified system (6) composed of several glass-like or ceramic layers (7, 8, 9) is deposited and structured and/or locally modified on the surface (5) of said base (4) for guidance and/or frequency conversion of the beam, in such a manner that a direct contact is created between said beam exit surface (2) and said stratified system (6) and a pre-determinable beam guidance is achieved,
**that** low-temperature processes are employed for depositing and structuring and/or local modification,
**that** at least one layer (8) of said wave-guiding stratified system (6) is formed of a laser-active material that is adapted to be excited by a first frequency of the beam emerging from said optoelectronic component (1) and that emits a radiation of a higher or lower second frequency in response to excitation, and
**that** a beam exit side (10) of said wave-guiding stratified system (6) and possibly said beam exit surface (2) of said optoelectronic component (1) are coated with a layer (11) partly reflecting the radiation of said second frequency, in order to form an optical resonator for radiation of said second frequency.

2. Method according to Claim 1,
**characterised in**
**that** at least three superimposed layers (7, 8, 9) are deposited as wave-guiding stratified system (6), whereof a middle layer (8) has a refractive index that is higher than the refractive index of the neighbouring layers (7, 9).

3. Method according to any of the Claims 1 to 2,
**characterised in**
**that** a metallic or ceramic base (4) is employed.

4. Method according to any of the Claims 1 to 3,
**characterised in**
**that** a cooling body is used as base (4).

5. Method according to any of the Claims 1 to 4,
**characterised in.**
**that** said optoelectronic component (1) and said base (4) are connected by soldering.

6. Method according to any of the Claims 1 to 5,
**characterised in**
**that** structuring is carried out while individual ones or all of said layers (7, 8, 9) of said stratified system (6) are deposited by application of one or several depositing masks.

7. Method according to any of the Claims 1 to 5,
**characterised in**
**that** structuring is carried out by local removal after individual ones or all of said layers (7, 8, 9) of said stratified system (6) have been deposited.

8. Method according to any of the Claims 1 to 7,
**characterised in**
**that** modification is carried out by locally restricted influence of energy for varying the characteristics of a layer, in particular its refractive index.

9. Method according to any of the Claims 1 to 8
**characterised in**
**that** one or several further layers are deposited and structured on said base (4) in direct contact with said wave-guiding stratified system (6), in order to constitute further optical components.

10. Method according to any of the Claims 1 to 9,
**characterised in**
**that** an optoelectronic component (1) with several beam exit surfaces (2) is used, with said wave-guiding stratified system (6) being structured and/or locally modified for guidance and/or frequency conversion of the beams emerging from said several beam exit surfaces (2).

11. Method according to Claim 10,
**characterised in**
**that** said wave-guiding stratified system (6) is so structured and/or locally modified that the beams emerging from said several beam exit surfaces (2) are converged onto a reduced beam exit surface.

12. Method according to any of the Claims 1 to 11,
**characterised in**
**that** an optoelectronic component (1) with one or several semiconductor diode lasers is used.

13. Beam-guiding and/or frequency-converting optical system wherein a beam-emitting optoelectronic component (1) comprising at least one beam exit surface (2) for emergence of a beam, is connected to a surface (5) of a base (4) in such a manner that the emerging beam extends approximately in parallel with the surface (5) of said base (4),
**characterised in**
**that** said beam-emitting optoelectronic component (1) is mounted on said surface (5) of said base (4) and that a structured wave-guiding stratified system (6) composed of several glass-like or ceramic layers (7, 8, 9) in direct contact with said beam exit surface (2) is deposited on the surface (5) of said base (4) for guidance and/or frequency conversion of the beam,
**that** at least one layer (8) of said wave-guiding stratified system (6) is formed of a laser-active material that is adapted to be excited by a first frequency of the beam emerging from said optoelectronic component (1) for emission of radiation of a higher or lower second frequency in response to excitation,
**that** a beam exit side (10) of said wave-guiding stratified system (6) and possibly said beam exit surface (2) of said optoelectronic component (1) are coated with a layer (11) partly reflecting the radiation of said second frequency for forming an optical resonator for radiation of said second frequency.

14. System according to Claim 13,
**characterised in**
**that** said wave-guiding stratified system (6) is formed of at least three superimposed layers (7, 8, 9) whereof a middle layer (8) presents a refractive index higher than the refractive index of the neighbouring layers (7, 9).

15. System according to any of the Claims 13 to 14,
**characterised in**
**that** said base (4) consists of metal or ceramic material.

16. System according to any of the Claims 13 to 15,
**characterised in**
**that** said base (4) is a cooling body.

17. System according to any of the Claims 13 to 16,
**characterised in**
**that** one or several further structured layers are deposited on said base (4) in direct contact with said wave-guiding stratified system (6), which constitute further optical components.

18. System according to any of the Claims 13 to 17,
**characterised in**
**that** said optoelectronic component (1) presents several beam exit surfaces (2), with said wave-guiding stratified system (6) being structured and/or locally modified for guidance and/or frequency conversion of the beams emerging from said several beam exit surfaces (2).

19. System according to Claim 18,
**characterised in**
**that** said wave-guiding stratified system (6) is so structured and/or locally modified that the beams emerging from said several beam exit surfaces (2) are converged onto a reduced beam exit surface.

20. System according to any of the Claims 13 to 19,
**characterised in**
**that** said optoelectronic component (1) includes one or several semiconductor diode lasers.

## Revendications

1. Procédé de fabrication d'un système optique de focalisation de faisceau et/ou de conversion de fréquence, dans lequel un composant optoélectronique émetteur d'un faisceau (1) comprenant au moins une surface de sortie de faisceau (2) pour l'émergence d'un faisceau, est disposé et relié à une surface (5) d'un support (4) d'une telle manière, que le faisceau émergent s'étende environ en parallèle à la surface (5) dudit support (4),
**caractérisé en ce**
**que** ledit composant optoélectronique (1) guide de faisceau est d'abord monté sur ladite surface (5) dudit support (4), et en ce qu'ensuite un système stratifié guide d'ondes (6), composé de plusieurs couches vitreuses ou céramiques (7, 8, 9), est déposé et structuré et/ou localement modifié sur la surface (5) dudit support (4) pour le guidage et/ou la conversion de fréquence du faisceau, d'une telle manière, qu'un contact direct soit établi entre ladite surface de sortie de faisceau (2) et ledit système stratifié (6) et un guidage de faisceau prédéterminable soit achevé,
en ce que des processus à basse température sont employés pour le dépôt et la structuration et/ou la modification locale,
en ce qu'au moins une couche (8) dudit système stratifié guide d'ondes (6) est formée d'un matériau actif de laser, qui est apte à être excité par une première fréquence du faisceau émergent dudit composant optoélectronique (1) et qui émet un rayonnement à une deuxième fréquence plus haute ou plus basse en réponse à l'excitation, et
en ce qu'un côté de sortie de faisceau (10) dudit système stratifié guide d'ondes (6) et éventuellement ladite surface de sortie de faisceau (2) dudit composant optoélectronique (1) sont revêtues d'une couche (11) partiellement réfléchissante le rayonnement de ladite deuxième fréquence afin de former un résonateur optique pour le rayonnement de ladite deuxième fréquence.

2. Procédé selon la revendication 1,
**caractérisé en ce**
**qu'**au moins trois couches superposées (7, 8, 9) sont déposées en tant qu'un système stratifié guide d'ondes (6), dont une couche centrale (8) présente un indice de réfraction plus haut que l'indice de réfraction des couches adjacentes (7, 9).

3. Procédé selon une quelconque des revendications 1 à 2,
**caractérisé en ce**
**qu'**un support métallique ou céramique (4) est utilisé.

4. Procédé selon une quelconque des revendications 1 à 3,
**caractérisé en ce**
**qu'**un corps refroidisseur est utilisé en tant que support (4).

5. Procédé selon une quelconque des revendications 1 à 4,
**caractérisé en ce**
**que** ledit composant optoélectronique (1) et ledit support (4) sont reliés par brasage.

6. Procédé selon une quelconque des revendications 1 à 5,
**caractérisé en ce**
**que** la structuration est réalisée au cours du dépôt des couches individuelles ou toutes desdites couches (7, 8, 9) dudit système stratifié (6) par emploi d'un ou de plusieurs masques de dépôt.

7. Procédé selon une quelconque des revendications 1 à 5,
**caractérisé en ce**
**que** la structuration est réalisée par enlèvement local après le dépôt des couches individuelles ou de toutes desdites couches (7, 8, 9) dudit système stratifié (6).

8. Procédé selon une quelconque des revendications 1 à 7,
**caractérisé en ce que**
la modification est réalisée par de l'influence localement limitée de l'énergie afin de varier les caractéristiques d'une couche, en particulier son indice de réfraction.

9. Procédé selon une quelconque des revendications 1 à 8
**caractérisé en ce**
**qu'**une ou plusieurs couches additionnelles sont déposées et structurées sur ledit support (4) en contact direct avec ledit système stratifié guide d'ondes (6) afin de constituer des composants optiques additionnels.

10. Procédé selon une quelconque des revendications 1 à 9,
**caractérisé en ce**
**qu'**un composant optoélectronique (1) à plusieurs surfaces de sortie de faisceau (2) est utilisé, audit système stratifié guide d'ondes (6) étant structuré et/ou localement modifié pour le guidage et/ou la conversion de fréquence des faisceaux émergents desdites plusieurs surfaces de sortie de faisceau (2).

11. Procédé selon la revendication 10,
**caractérisé en ce**
**que** ledit système stratifié guide d'ondes (6) est structuré et/ou localement modifié d'une telle façon, que les faisceaux émergents desdites plusieurs surfaces de sortie de faisceau (2) soient convergés sur une surface réduite de sortie de faisceau.

12. Procédé selon une quelconque des revendications 1 à 11,
**caractérisé en ce**
**qu'**un composant optoélectronique (1) à un ou plusieurs lasers de diode semi-conducteurs est employé.

13. Système optique de focalisation de faisceau et/ou de conversion de fréquence. dans lequel un composant optoélectronique émetteur d'un faisceau (1), qui comprend au moins une surface de sortie de faisceau (2) pour l'émergence d'un faisceau, est relié à une surface (5) d'un support (4) d'une telle façon, que le faisceau émergent s'étende environ en parallèle à la surface (5) dudit support (4),
**caractérisé en ce**
**que** ledit composant optoélectronique émetteur d'un faisceau (1) est monté sur ladite surface (5) dudit support (4), et en ce qu'un système structuré stratifié guide d'ondes (6) composé de plusieurs couches vitreuses ou céramiques (7, 8, 9) en contact direct avec ladite surface de sortie de faisceau (2) et déposé sur la surface (5) dudit support (4) pour le guidage et/ou la conversion de fréquence du faisceau,
en ce qu'au moins une couche (8) dudit système stratifié guide d'ondes (6) est formé d'un matériau actif de laser, qui est apte à être excité par une première fréquence du faisceau émergent dudit composant optoélectronique (1) pour l'émission d'un rayonnement à une deuxième fréquence plus haute ou plus basse en réponse à l'excitation,
en ce qu'un côté de sortie de faisceau (10) dudit système stratifié guide d'ondes (6) et éventuellement ladite surface de sortie de faisceau (2) dudit composant optoélectronique (1) sont revêtus d'une couche (11) partiellement réfléchissante le rayonnement de ladite deuxième fréquence afin de constituer un résonateur optique pour le rayonnement de ladite deuxième fréquence.

14. Système selon la revendication 13,
**caractérisé en ce**
**que** ledit système stratifié guide d'ondes (6) est constitué par au moins trois couches superposées (7, 8, 9), dont une couche centrale (8) présente un indice de réfraction plus haut que l'indice de réfraction des couches adjacentes (7, 9).

15. Système selon une quelconque des revendications 13 à 14,
**caractérisé en ce**
**que** ledit support (4) consiste en un matériau métallique ou céramique.

16. Système selon une quelconque des revendications 13 à 15,
**caractérisé en ce**
**que** ledit support (4) est un corps de refroidissement.

17. Système selon une quelconque des revendications 13 à 16,
**caractérisé en ce**
**qu'**une ou plusieurs couches structurées additionnelles sont déposées sur ledit support (4) en contact direct avec ledit système stratifié guide d'ondes (6), qui constituent des composants optiques additionnels.

18. Système selon une quelconque des revendications 13 à 17,
**caractérisé en ce**
**que** ledit composant optoélectronique (1) présente plusieurs surfaces de sortie de faisceau (2), audit système stratifié guide d'ondes (6) étant structuré et/ou localement modifié pour le guidage et/ou la conversion de fréquence des faisceaux émergents desdites plusieurs surfaces de sortie de faisceau (2).

19. Système selon la revendication 18,
**caractérisé en ce**
**que** ledit système stratifié guide d'ondes (6) est structuré et/ou localement modifié d'une telle façon, que les faisceaux émergents desdites plusieurs surfaces de sortie de faisceau (2) sont convergés sur une surface réduite de sortie de faisceau.

20. Système selon une quelconque des revendications 13 à 19,
**caractérisé en ce**
**que** ledit composant optoélectronique (1) renferme un ou plusieurs lasers à diode semi-conducteurs.
